(19) Europäisches Patentamt / European Patent Office / Office européen des brevets

(11) **EP 3 101 810 A1**

(12) **EUROPEAN PATENT APPLICATION**

(43) Date of publication:
07.12.2016 Bulletin 2016/49

(51) Int Cl.:
*H03K 17/16* (2006.01)     *H03K 17/567* (2006.01)
*H03K 17/04* (2006.01)     *H03K 17/06* (2006.01)

(21) Application number: 16170649.4

(22) Date of filing: 20.05.2016

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 04.06.2015 KR 20150079102

(71) Applicant: LSIS Co., Ltd.
Gyeonggi-do 14119 (KR)

(72) Inventor: KIM, Kwang-Woon
14118 Gyeonggi-do (KR)

(74) Representative: Zacco Sweden AB
P.O. Box 5581
114 85 Stockholm (SE)

(54) **APPARATUS FOR DRIVING IGBT**

(57) The present invention relates to an apparatus for driving a single power supply of a high power Insulated Gate Bipolar Transistor, IGBT. The apparatus includes a gate driver IC configured to supply a signal for driving the IGBT; an external capacitor (Cge_ext) connected between a gate (G) and an emitter (E) of the IGBT; a signal inverter (430) configured to invert an output signal of the gate driver IC; and a switch (440) configured to supply power to the external capacitor in response to an output signal of the signal inverter (430).

FIG. 4

EP 3 101 810 A1

## Description

### BACKGROUND

1. Technical Field

The present invention relates to an apparatus for driving an Insulated Gate Bipolar Transistor, IGBT, and more particularly, to an apparatus for driving a single power supply of a high power IGBT.

2. Description of the Related Art

As a kind of power semiconductor, an IGBT (Insulated Gate Bipolar Transistor) is mainly in wide use in a voltage region of 300V or higher, particularly in a high-efficiency high-speed power system.

A dual power supply or single power supply is used to such IGBT.

A dual power supply refers to a power supply which uses a positive (+) voltage as a turn-on voltage and a negative (-) voltage as a turn-off voltage to drive an IGBT element. The dual power supply has a merit in that it may not consider a parasitic turn-on voltage which is caused by Miller capacitance and stray inductance, whereas it has a demerit from the viewpoint of installation cost and space.

In contrast, a single power supply refers to a power supply which uses a positive (+) voltage as a turn-on voltage and a zero (0) voltage as a turn-off voltage. The single power supply has a merit from the viewpoint of installation cost and space since it requires the less number of elements used, whereas it has a demerit in that parasitic turning-on may be caused by Miller capacitance and stray inductance.

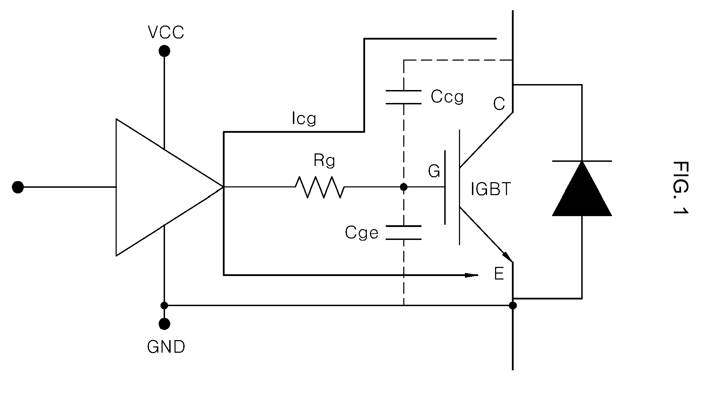

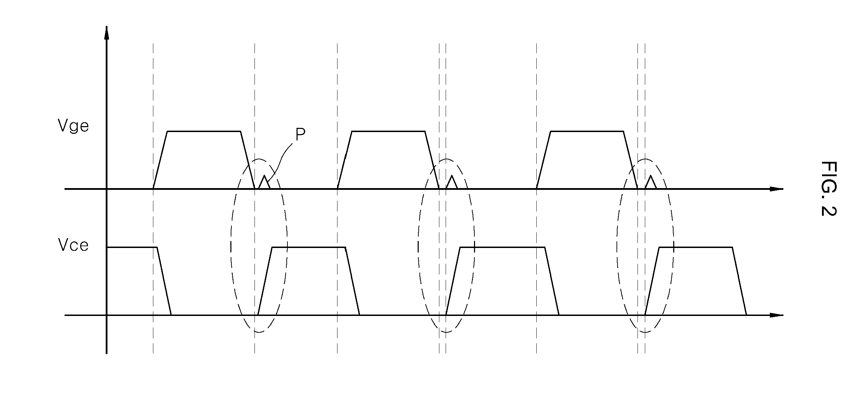

Fig. 1 is an explanatory view showing a conventional IGBT single power supply driver and Fig. 2 is a graph used to explain a parasitic turn-on effect caused by the IGBT single power supply driver of Fig. 1.

Referring to Figs. 1 and 2, when a collector-emitter voltage Vce of IGBT rises, a current Icg is produced by collector-gate Miller capacitance. A collector-gate current Icg can be obtained according to the following equation 1.

[Eq. 1]

$$Icg = Ccg \times (dV_{ce} / dt)$$

The collector-gate current Icg is converted into a voltage by a gate resistor Rg. As indicated by a dotted line in Fig. 2, it can be seen that a parasitic voltage P due to the gate resistor Rg is generated at a rising edge of the collector-emitter voltage Vce.

In addition, there is a problem that the parasitic voltage P may turn on the IGBT unintentionally.

### SUMMARY

To overcome the above problems, it is an aspect of the present invention to provide an apparatus for driving a high power IGBT.

The present invention is not limited to the above aspect and other aspects of the present invention will be clearly understood by those skilled in the art from the following description. In addition, it should be understood that the aspects and advantages of the present invention can be achieved by elements and combinations thereof set forth in the claims.

In accordance with one aspect of the present invention, there is provided an apparatus for driving an IGBT, including: a gate driver IC configured to supply a signal for driving the IGBT; an external capacitor connected between a gate and an emitter of the IGBT; a signal inverter configured to invert an output signal of the gate driver IC; and a switch configured to supply power to the external capacitor in response to an output signal of the signal inverter.

In some embodiments, the switch may open the external capacitor when the output signal of the gate driver IC has a high level, and may short-circuit the external capacitor when the output signal of the gate driver IC has a low level.

In some embodiments, when the output signal of the gate driver IC has a high level, the IGBT may be turned on and the switch may be turned off.

In some embodiments, when the output signal of the gate driver IC has a low level, the IGBT may be turned off, the switch may be turned on in response to an output signal having a high level supplied from the signal inverter, and the external capacitor may be charged with power supplied via the turned-on switch.

In some embodiments, the signal inverter may be composed of a NOT gate.

In some embodiments, the signal inverter is composed of a switching element for outputting an inverted signal.

According to one embodiment of the present invention, it is possible to prevent additional power consumption due to a gate-emitter capacitor included in a typical IGBT single power supply driver.

Accordingly, it is possible to provide an IGBT single power supply driver which is capable of preventing a parasitic turn-on voltage from occurring without additional consumption, thereby allowing the driver to be operated with higher stability and efficiency.

### BRIEF DESCRIPTION OF DRAWINGS

Fig. 1 is an explanatory view showing a conventional IGBT single power supply driver.
Fig. 2 is a graph used to explain a parasitic turn-on effect caused by the IGBT single power supply driver of Fig. 1.

Fig. 3 is an explanatory view showing a typical IGBT single power supply driver.

Fig. 4 is an explanatory view showing an IGBT single power supply driver according to one embodiment of the present invention.

Fig. 5 is an explanatory view showing an IGBT single power supply driver according to another embodiment of the present invention.

Fig. 6 is a graph used to explain signal waveforms applied to an IGBT single power supply driver according to an embodiment of the present invention.

## DETAILED DESCRIPTION

Hereinafter, aspects, features and advantages of the present invention will be described in detail with reference to the accompanying drawings so that those skilled in the art can easily practice the technical ideas of the present invention. In the following detailed description of the present invention, concrete description on related functions or constructions will be omitted if it is deemed that the functions and/or constructions may unnecessarily obscure the gist of the present invention.

Some preferred embodiments of the present invention will now be described in detail with reference to the accompanying drawings. Throughout the drawings, the same or similar elements are denoted by the same reference numerals.

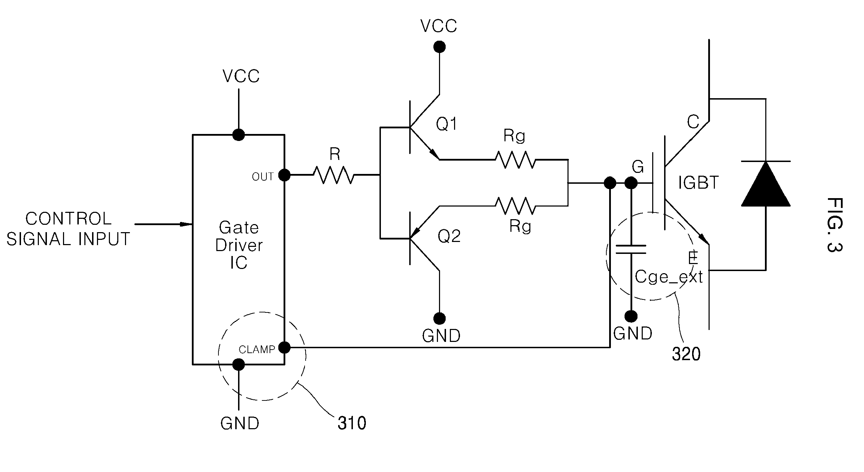

Fig. 3 is an explanatory view showing a typical Insulated Gate Bipolar Transistor, IGBT, single power supply driver.

Referring to Fig. 3, a typical IGBT single power supply driver is provided to overcome the problems described with reference to Figs. 1 and 2 and includes a gate driver IC for applying a control signal through an IGBT gate terminal. The gate driver IC has a clamp terminal 310 with an active Miller clamp function. In addition, an external capacitor (Cge_ext) 320 is interposed between the gate and the emitter of an IGBT. For reference, the active Miller clamp function refers to a function of reducing electrical vibration produced by Miller capacitance existing between the gate and the drain of the IGBT in an active way.

That is, by preventing generation of a parasitic turn-on voltage through charging/discharging of the external capacitor 320 while discharging a current Icg through the clamp terminal 310 of the gate driver IC, the IGBT single power supply driver acts to be driven without malfunction due to the generation of the parasitic turn-on voltage.

Accordingly, since the stability of driving of the IGBT is improved with increase in the capacitance of the external capacitor 320, a circuit may be configured so as to maximize the capacitance of the external capacitor 320 through parallel connection of the capacitor.

However, in this case, in addition to power for turning on/off the IGBT, power is further required to charge/discharge the external capacitor 320.

In other words, power Pg for driving only the IGBT element can be obtained according to the following equation 2. V is a driving voltage, Qg is gate charge and $f_c$ is a switching frequency.

$$[Eq. 2]$$

$$Pg = V \times Qg \times f_c$$

However, when the external capacitor 320 shown in Fig. 3 is added, the power Pg required by the IGBT single power supply driver is obtained according to the following equation 3. Cge is gate-emitter capacitance

$$[Eq. 3]$$

$$Pg = (V \times Qg \times f_c) + (Cge \times f_c \times V^2)$$

That is, the typical IGBT single power supply driver as shown in Fig. 3 requires additional power for charging/discharging of the gate-emitter 1 capacitor 320.

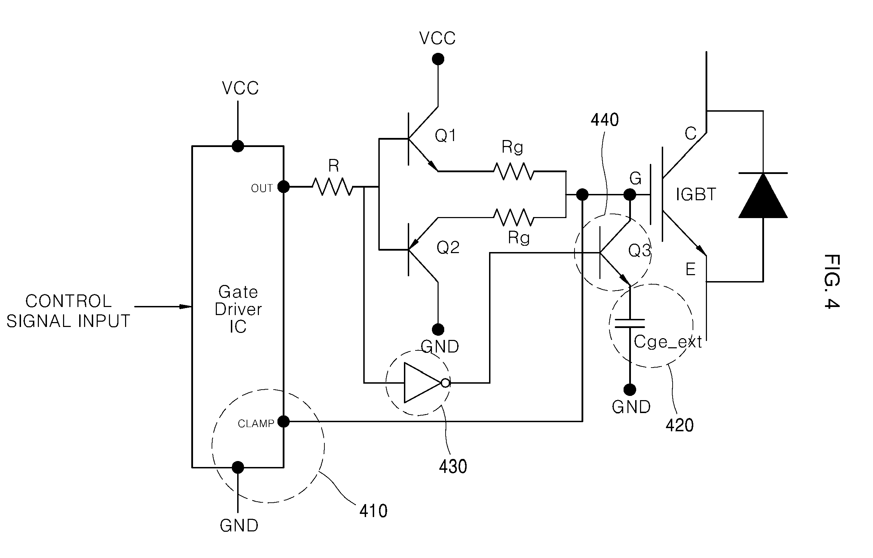

Fig. 4 is an explanatory view showing an IGBT single power supply driver according to one embodiment of the present invention.

Referring to Fig. 4, an IGBT single power supply driver according to one embodiment of the present invention includes a signal inverter 430 connected to an output terminal of the gate driver IC and a switch 440 for switching power applied to the external capacitor 420 in correspondence to an output signal of the signal inverter 430, in addition to the typical IGBT single power supply driver as shown in Fig. 3.

The gate driver IC outputs a driving signal of the IGBT in correspondence to an input control signal.

The driving signal output from the gate driver IC is input to a gate terminal of the IGBT element via switching elements Q1 and Q2 and gate resistors Rg. In this case, a current Icg is flown between the collector and the gate of the IGBT and is converted into a parasitic turn-on voltage via the gate resistors Rg, as described earlier.

As described above, the IGBT single power supply driver as shown in Fig. 3 is suggested to overcome this problem. This IGBT single power supply driver prevents generation of the parasitic turn-on voltage through the charging/discharging of the external capacitor while discharging the current Icg via the clamp terminal of the gate driver IC. Thus, the IGBT single power supply driver acts to be driven without malfunction due to the generation of the parasitic turn-on voltage.

However, the above-described typical IGBT single power supply driver requires additional power for driving of the external capacitor.

To overcome this problem, as shown in Fig. 4, the IGBT single power supply driver according to one embodiment of the present invention includes the signal inverter 430 such as a NOT gate or the like and the switch 440 such as a transistor, in addition to the above-described typical IGBT single power supply driver. More specifically, the IGBT single power supply driver according to one embodiment of the present invention includes the external capacitor 420 connected between the gate G and the emitter E of the IGBT, the signal inverter 430 for inverting the output signal of the gate driver IC, and the switch 440 for supplying power to the external capacitor 420based on the output signal of the signal inverter 430.

In other words, the signal inverter 430 connected to the output terminal of the gate driver IC applies an inverted signal, which is obtained by inverting a signal applied to the IGBT, to the switch 440 through which power is then supplied to the external capacitor 420. Therefore, when the output signal of the gate driver IC has a high level, power for turning on the IGBT can be fully used as a driving signal of the IGBT. Conversely, when the output signal of the gate driver IC has a low level, a driving signal is used to charge the external capacitor 420 by means of the signal inverter 430, thereby preventing additional power consumption.

That is, the signal inverter 430 acts to output an Off signal to open the external capacitor 420 when the output signal of the gate driver IC has the high level and acts to output an On signal to short-circuit the external capacitor 420 when the output signal of the gate driver IC has the low level.

Accordingly, it is possible to overcome a parasitic turn-on voltage problem of the IGBT single power supply driver without additional power consumption for charging/discharging of the external capacitor 420.

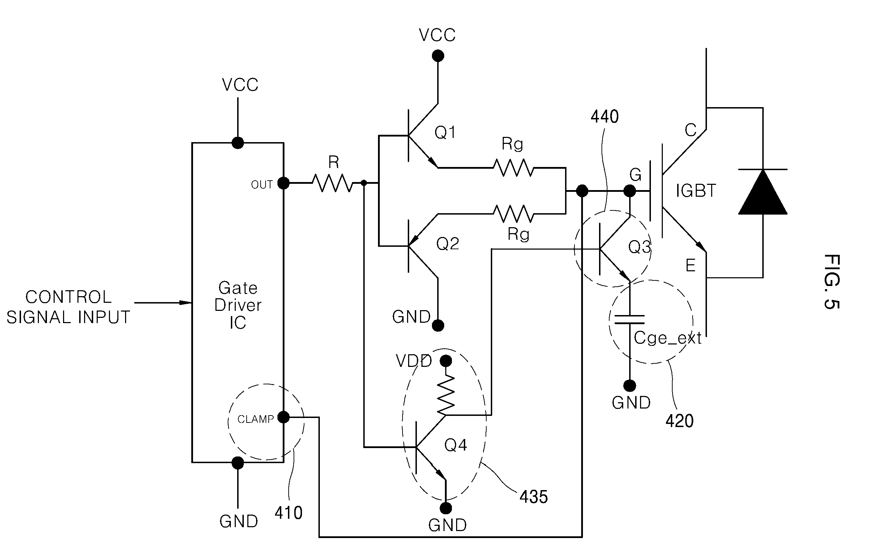

Fig. 5 is an explanatory view showing an IGBT single power supply driver according to another embodiment of the present invention.

Referring to Fig. 5, an IGBT single power supply driver according to another embodiment of the present invention includes a signal inverter 435 which is composed of a switching element instead of the NOT gate in the IGBT single power supply driver shown in Fig. 4.

As described with reference to Fig. 4, the driving signal supplied from the gate driver IC is applied to the gate terminal of the IGBT and the inverted signal thereof is applied to the external capacitor 420 via the switch 440. In contrast, Fig. 5 shows a modification in which the signal inverter 435 is configured with a switching element instead of the NOT gate.

Specifically, the signal inverter 435 is implemented with a switching element such as a transistor and, when an output voltage of the gate driver IC is applied to a base terminal of the transistor, an output signal produced at a collector terminal of the transistor is used as an input signal of the switch 440. Thus, an inverted signal of the driving signal of the gate driver IC applied to the gate terminal of the IGBT is applied to the switch 440 via the signal inverter 435.

However, this embodiment is just illustrative and it should be understood by those skilled in the art that the signal inverter 435 for generating an inverted signal of the output signal of the gate driver IC and supplying the inverted signal to the switch 440 may be implemented according to any schemes known in the art.

As described above, the signal inverter 435 connected to the output terminal of the gate driver IC applies the inverted signal of the signal applied to the IGBT to the switch 440 and power is supplied to the external capacitor 420 via the switch 440. Therefore, when the output signal of the gate driver IC has a high level, power for turning on the IGBT can be fully used as a driving signal of the IGBT. Conversely, when the output signal of the gate driver IC has a low level, a driving signal is used to charge the external capacitor 420 by means of the signal inverter 435, thereby preventing additional power consumption, as described above with reference to Fig. 4.

That is, the signal inverter 435 acts to output an Off signal to open the external capacitor 420 when the output signal of the gate driver IC has the high level and acts to output an On signal to short-circuit the external capacitor 420 when the output signal of the gate driver IC has the low level.

Accordingly, it is possible to overcome a parasitic turn-on voltage problem of the IGBT single power supply driver without additional power consumption for charging/discharging of the external capacitor 420, as described above.

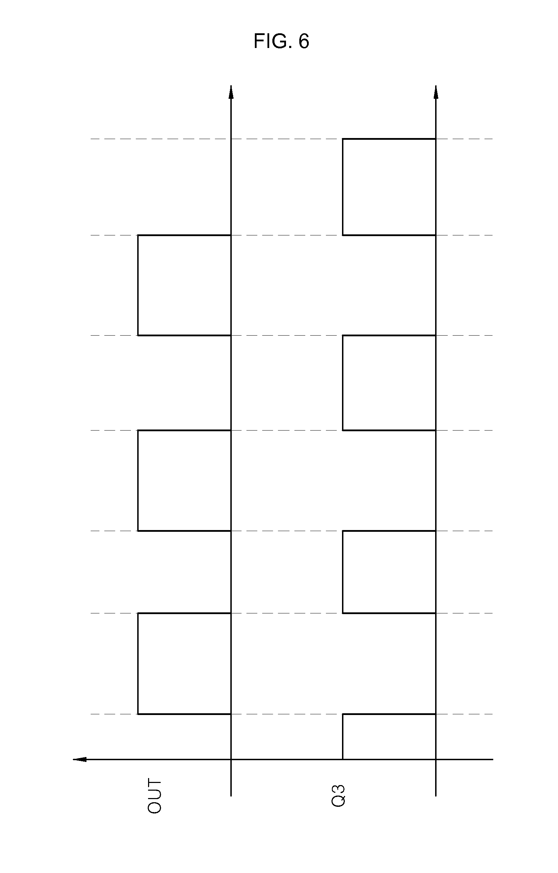

Fig. 6 is a graph used to explain signal waveforms applied to an IGBT single power supply driver according to an embodiment of the present invention

Referring to Fig. 6, a signal Q3 for driving the switch 440 has the opposite waveform to the output signal OUT of the gate driver IC. This makes it possible to provide power for charging/discharging of the external capacitor without supply of additional power.

Such an effect is shown to allow the IGBT single power supply driver to be operated with relatively little power while allowing the IGBT single power supply driver to be operated with higher stability and efficiency when the same power is used.

In other words, since the parasitic turn-on voltage is suppressed with increase in the capacitance of the external capacitor, even when an external capacitor with high capacitance is used or the external capacitor is implemented by parallel connection of a number of capacitors, the IGBT single power supply driver according to the embodiments of the present invention has an advantage that it can be operated with less power consumption than the typical IGBT single power supply driver.

To summarize, the IGBT single power supply driver according to the embodiments of the present invention includes a gate driver IC for outputting a control signal to drive an IGBT, an external capacitor connected between a gate and an emitter of the IGBT, a signal inverter for inverting an output signal of the gate driver IC, and a switch for supplying power to the external capacitor when the switch is turned on in response to the output signal of the signal inverter. The switch is turned on in response to an inverted signal of a signal output from the gate driver IC and is accordingly driven in the opposite way to the IGBT. That is, when the IGBT is turned off, the output signal of the gate driver IC is inverted by the signal inverter to turn on the switch and is supplied as power to the external capacitor. Thus, according to the embodiments of the present invention, it is possible to provide an IGBT single power supply driver which is capable of preventing a parasitic turn-on voltage due to an external capacitor and eliminating additional power form the external capacitor, thereby allowing the driver to be applied with higher stability and efficiency.

While certain embodiments have been described, these embodiments have been presented by way of example only, and are not intended to limit the scope of the disclosures. Indeed, the novel methods and apparatuses described herein may be embodied in a variety of other forms; furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

**Claims**

1. An apparatus for driving an Insulated Gate Bipolar Transistor, IGBT, including a gate driver IC configured to supply a signal for driving the IGBT, the apparatus comprising:

   an external capacitor (Cge_ext) connected between a gate (G) and an emitter (E) of the IGBT;
   a signal inverter (430) configured to invert an output signal of the gate driver IC; and
   a switch (440) configured to supply power to the external capacitor in response to an output signal of the signal inverter (430).

2. The apparatus according to claim 1, wherein the switch (440) opens the external capacitor (Cge_ext) when the output signal of the gate driver IC has a high level, and short-circuits the external capacitor when the output signal of the gate driver IC has a low level.

3. The apparatus according to claim 1 or claim 2, wherein, when the output signal of the gate driver IC has a high level, the IGBT is turned on and the switch (440) is turned off, and
   wherein, when the output signal of the gate driver IC has a low level, the IGBT is turned off, the switch (440) is turned on in response to an output signal having a high level supplied from the signal inverter (430), and the external capacitor (Cge ext) is charged with power supplied via the turned-on switch (440).

4. The apparatus according to any one of claim 1 to claim 3, wherein the signal inverter (430) is composed of a NOT gate.

5. The apparatus according to any one of claim 1 to claim 3, wherein the signal inverter (435) is composed of a switching element (Q4) for outputting an inverted signal.

FIG. 1

FIG. 2

## FIG. 3

FIG. 4

FIG. 5

FIG. 6

Europäisches Patentamt

European Patent Office

Office européen des brevets

# EUROPEAN SEARCH REPORT

Application Number

EP 16 17 0649

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/058499 A1 (YAMASHIRO KEISUKE [JP] ET AL) 5 March 2009 (2009-03-05) * paragraph [0024]; figures 1,2 * | 1-5 | INV. H03K17/16 H03K17/567 |
| X | JP 2000 333441 A (TOSHIBA CORP) 30 November 2000 (2000-11-30) * paragraph [0024] - paragraph [0025]; figures 1,2 * | 1-5 | ADD. H03K17/04 H03K17/06 |
| A | US 7 898 303 B2 (BARRENSCHEEN JENS [DE]) 1 March 2011 (2011-03-01) * column 4, line 41 - line 61; figure 4 * | 1-5 | |
| A | US 2004/041201 A1 (SUGIYAMA KOICHI [JP] ET AL) 4 March 2004 (2004-03-04) * paragraph [0136] - paragraph [0146]; figures 18,19,21 * | 1-5 | |
| A | US 2003/075748 A1 (FURUIE TOSHIYUKI [JP] ET AL) 24 April 2003 (2003-04-24) * paragraph [0070] - paragraph [0073]; figures 10,12 * | 1-5 | TECHNICAL FIELDS SEARCHED (IPC) H03K H02M |

The present search report has been drawn up for all claims

| Place of search | Date of completion of the search | Examiner |
|---|---|---|
| The Hague | 12 October 2016 | O'Reilly, Siobhan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 17 0649

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2016

| Patent document cited in search report | | Publication date | Patent family member(s) | | Publication date |
|---|---|---|---|---|---|
| US 2009058499 | A1 | 05-03-2009 | JP | 5401774 B2 | 29-01-2014 |
| | | | JP | 2009055696 A | 12-03-2009 |
| | | | US | 2009058499 A1 | 05-03-2009 |
| | | | US | 2014097876 A1 | 10-04-2014 |
| JP 2000333441 | A | 30-11-2000 | JP | 3568823 B2 | 22-09-2004 |
| | | | JP | 2000333441 A | 30-11-2000 |
| US 7898303 | B2 | 01-03-2011 | DE | 102009046255 A1 | 06-05-2010 |
| | | | US | 2010109750 A1 | 06-05-2010 |
| | | | US | 2010327946 A1 | 30-12-2010 |
| US 2004041201 | A1 | 04-03-2004 | JP | 2004014547 A | 15-01-2004 |
| | | | US | 2004041201 A1 | 04-03-2004 |
| | | | US | 2007040184 A1 | 22-02-2007 |
| | | | US | 2007040185 A1 | 22-02-2007 |
| US 2003075748 | A1 | 24-04-2003 | JP | 3788926 B2 | 21-06-2006 |
| | | | JP | 2003133929 A | 09-05-2003 |
| | | | US | 2003075748 A1 | 24-04-2003 |

EPO FORM P0459

For more details about this annex : see Official Journal of the European Patent Office, No. 12/82